# EUROPEAN PATENT APPLICATION

(11) **EP 1 638 118 A2**
(43) Date of publication of application: **22.03.2006**
(21) Application number: 05019775.5
(22) Date of filing: 12.09.2005
(51) Int. Cl.: H01F 27/28

(54) **Coupling coil**

(30) Priority: 17.09.2004 JP 2004272036
(71) Applicant: ALPS ELECTRIC CO., LTD., Ota-ku Tokyo 145 (JP)
(72) Inventor: Osada, Shigeru, Ota-ku Tokyo 145 (JP)
(74) Representative: Klunker . Schmitt-Nilson . Hirsch

(57) **Abstract**

A coupling coil is provided which includes a first coil (1) spirally formed on one surface of the insulating substrate (10); a second coil (2) spirally formed on the one surface so as to spirally rotate around adjacent conductors of the first coil and be concentrically arranged with the first coil; a third coil (3) spirally formed on the other surface of the insulating substrate (10); and a fourth coil (4) spirally formed on the other surface so as to spirally rotate around adjacent conductors of the third coil and be concentrically arranged with the third coil. In the coupling coil, one end (1a) positioned at the central portion of the first coil is connected to one end (3a) positioned at the central portion of the third coil, and one end (2a) positioned at the central portion of the second coil is connected to one end (4a) positioned at the central portion of the fourth coil.

## Description

### BACKGROUND OF THE INVENTION

### 1. Field of the Invention

The present invention relates to a coupling coil composed of a primary coil and a secondary coil formed on an insulating substrate by a printing method, etc.

### 2. Description of the Related Art

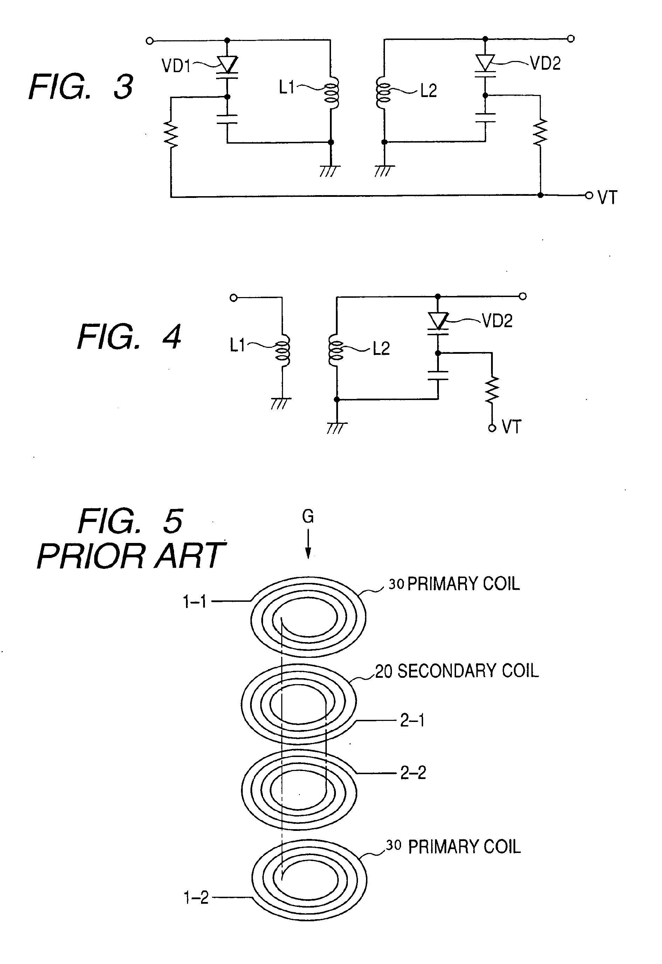

A coupling coil according to the related art will be described with reference to Fig. 5. In Fig. 5, two conductor formed faces 2-1 and 2-2 of a secondary coil adjacent to each other are coupled with each other at the centers of the spiral patterns of them. Two conductor formed faces 1-1 and 1-2 of a primary coil are coupled with each other at the centers of the spiral patterns of them and are arranged so as to interpose the two conductor formed planes 2-1 and 2-2 of the secondary coil therebetween.

Two electromagnetic coupling planes of the primary and secondary coils include an electromagnetic coupling plane defined by the conductor forming faces 1-1 and 2-1 and an electromagnetic coupling plane defined by the conductor formed faces 1-2 and 2-2. As for an AC resistance, into the conductor formed faces 1-1 and 1-2 of the primary coil opposite to each other and the conductor formed faces 2-1 and 2-2 of the secondary coil opposite to each other, currents flow in the opposite directions, respectively, whereby a magnetic field is closed between these coils. Therefore, increase of the resistance due to the proximity effect is suppressed. Further, when the voltage at the primary side is higher than the voltage at the secondary side, a gap between the two conductors formed faces 1-1 and 1-2 of the primary coil increases as compared to that in a conventional coupling coil, whereby the stray capacitance decreases from 1/10 to 1/2.

Next, the winding directions of the spiral coils with an isotopic pattern will be described. The conductor formed faces 1-1 and 2-1 at the upper side are wound left and the conductor formed faces 1-2 and 2-2 at the lower side are wound right. Here, the winding left means that the spiral shape toward the center from the outer terminal is counter-clockwise when viewing the conductor pattern from the direction of an arrow G. Also, the winding right means that the spiral shape toward the center from the outer terminal is clockwise when viewing the conductor pattern from the direction of the arrow G.

In this construction, since the AC GND is connected between the terminals 1-1 and 2-1, the electrical potential increases in proportion to a number of turns. Between the conductor formed faces 1-2 and 2-1, the AC potential increases toward the inner circumferential portion from the outer circumferential portion, and between the conductor formed faces 1-2 and 2-2, the AC potential increases toward the outer circumferential portion from the inner circumferential portion. Accordingly, the conductor formed faces 1-1 and 2-1 and the conductor formed faces 1-2 and 2-2 have the same electrical potential gradient in the radial direction, thereby decreasing the stray capacitance (for example, see Japanese Unexamined Patent Application Publication No. 06-302443 (Fig. 1)).

In the related art, since an insulating substrate having four conductor layers is used, the material cost rises and the number of manufacturing processes increases.

### SUMMARY OF THE INVENTION

An object of the invention is to provide a coupling coil capable of reducing the number of manufacturing processes by using an inexpensive insulating substrate, by forming a primary coil and a secondary coil on both surfaces of the insulating substrate, respectively, and connecting the primary and secondary coils to each other.

In order to achieve the above object, according to a first aspect of the invention, a coupling coil is provided which includes a first coil spirally formed on one surface of an insulating substrate; a second coil spirally formed on the one surface of the insulating substrate so as to spirally rotate around adjacent conductors of the first coil and be concentrically arranged with the first coil; a third coil spirally formed on the other surface of the insulating substrate; and a fourth coil spirally formed on the other surface of the insulating substrate so as to spirally rotate around adjacent conductors of the third coil and be concentrically arranged with the third coil. In the coupling coil, one end positioned at the central portion of the first coil is connected to one end positioned at the central portion of the third coil, one end positioned at the central portion of the second coil is connected to one end positioned at the central portion of the fourth coil, the first coil and the third coil are wound in the same direction on the same perspective plane, and the second coil and the fourth coil are wound in the same direction on the same perspective plane.

According to a second aspect of the invention, in the above-mentioned construction, it is preferable that a first conductor land be provided at a position on the one surface corresponding to the other end of the third coil and be connected to the other end of the third coil through a third via hole, and a second conductor land be provided at a position on the one surface of the insulating substrate corresponding to the other end of the fourth coil and be connected to the other end of the fourth coil through a fourth via hole.

According to a third aspect of the invention, in the above-mentioned construction, it is preferable that the one end of the first coil and the one end of the third coil be connected to each other through a first via hole, and the one end of the second coil and the one end of the fourth coil be connected to each other through a second via hole.

According to the first aspect, the first coil and the second coil are concentrically formed on the one surface of the insulating substrate and the third coil and the fourth coil are concentrically formed on the other surface of the insulating substrate. Further, the one end positioned at the central portion of the first coil is connected to the one end positioned at the central portion of the third coil, and the one end positioned at the central portion of the second coil is connected to the one end positioned at the central portion of the fourth coil. Furthermore, the first coil and the third coil are wound in the same direction in the same perspective plane and the second coil and the fourth coil are wound in the same direction as seen from the same perspective plane. Therefore, the first coil and the third coil constitute a primary coil and the second coil and the fourth coil constitute a secondary coil. The primary coil and the secondary coil are electromagnetically connected to each other.

According to the second aspect, the first conductor land is formed on the one surface at the position corresponding to the other end of the third coil and is connected to the other end of the third coil through the third via hole. Further, the second conductor land is formed on the one surface at the position corresponding to the other end of the fourth coil and is connected to the other end of the fourth coil through the fourth via hole. Therefore, both ends of the primary coil and both ends of the secondary coil can be arranged on the same surface.

According to the third aspect, the one end of the first coil and the one end of the third coil are connected to each other through the first via hole, and the one end of the second coil and the one end of the fourth coil are connected to each other through the second via hole, respectively. Therefore, the coils on both surfaces can be connected to each other by using a usual means.

### BRIEF DESCRIPTION OF THE DRAWINGS

Fig. 1A is a view showing a pattern of a coupling coil according to an embodiment of the invention as seen from one surface of an insulating substrate;
Fig. 1B is a view showing a pattern of the coupling coil according to the embodiment of the invention as seen from the other surface of the insulating substrate;
Fig. 2A is a perspective view of a primary coil of the coupling coil as seen from the one surface of the insulating substrate;
Fig. 2B is a perspective view of a secondary coil of the coupling coil as seen from the other surface of the insulating substrate;
Fig. 3 is a circuit diagram showing an example where the coupling coil of the invention is used;
Fig. 4 is a circuit diagram showing another example where the coupling coil according to the embodiment of the invention is used; and
Fig. 5 is a view showing a connection example of a coupling coil according to the related art.

### DESCRIPTION OF THE PREFERRED EMBODIMENT

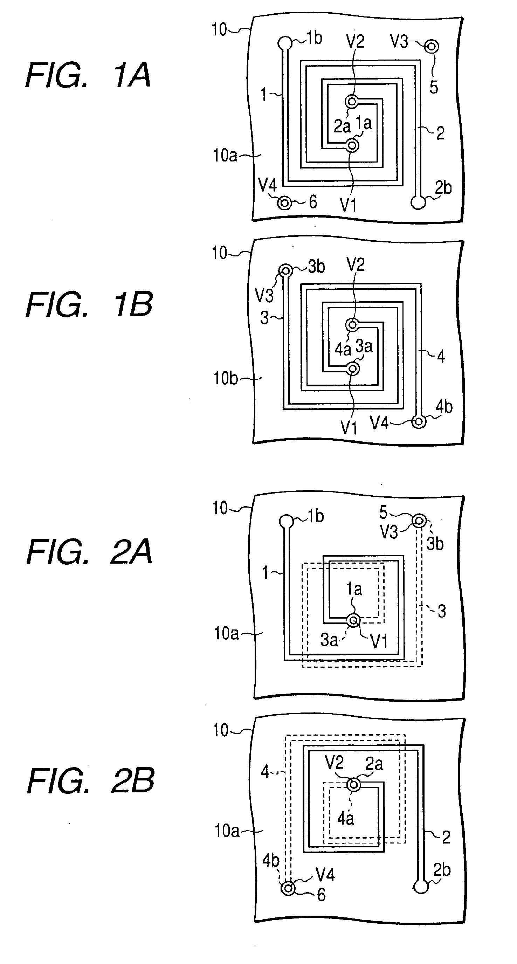

A coupling coil of the invention will be described with reference to Figs. 1 and 2. Fig. 1A is a view showing a pattern on one surface of an insulating substrate 10 and Fig. 1B is a view showing a pattern on the other surface of the insulating substrate 10. Fig. 2A is a perspective view of a primary coil seen from the one surface of the insulating substrate 10 and Fig. 2B is a perspective view of a secondary coil from the one surface of the insulating substrate 10.

A first coil 1 constituting a primary coil is spirally formed on one surface 10a of the insulating substrate 10 as shown in Fig. 2A. A second coil 2 constituting a secondary coil also is spirally formed on the one surface 10a so as to spirally rotate around adjacent conductors of the first coil 1. The first coil 1 and the second coil 2 are concentrically arranged with each other.

Accordingly, the conductors of the two coils 1 and 2 are alternatively arranged in a radial direction. One end 1a of the first coil 1 and one end 2a of the second coil 2 are arranged at the central portions of the coils 1 and 2 and the other ends 1b and 2b of the coils are arranged in the outer circumferential portion of the coils 1 and 2, respectively. Therefore, the first coil 1 and the second coil 2 are wound in the same direction (the counter-clockwise direction in Fig. 1A) from the other ends 1b and 2b serving as a starting point. The other end 1b of the first coil 1 and the other end 2b of the second coil 2 are symmetric with respect to the central point. Further, via holes V1 and V2 for leading the one ends 1a and 2a to the other surface 10b (a rear surface) of the insulating substrate 10 are provided at the one ends 1a and 2a, respectively.

A third coil 3 constituting the primary coil and a fourth coil 4 constituting the secondary coil are spirally formed on the other surface 10b of the insulating substrate 10, as shown in Fig. 1B. The relationship between the coils 3 and 4 is same as the relationship between the first coil 1 and the second coil 2, and the coils 3 and 4 are concentrically arranged. An end 3a of the third coil 3 and an end 4a of the fourth coil 4 are arranged at the central portions of the coils 3 and 4, and the other end 3b of the third coil 3 and the other end 4b of the fourth coil 4 are arranged in the outer circumferential portion of the coils 3 and 4. Accordingly, the coils 3 and 4 are wound in the same direction (counter-clockwise direction in Fig. 1B) from the other ends 3b and 4b, respectively. The other ends 3b and 4b are symmetrical with respect to the central point.

Further, the one end 3a of the third coil 3 is connected to the one end 1a of the first coil 1 through the via hole V1, and the one end 4a of the fourth coil 4 is connected to the one end 2a of the second coil 2 through the via hole V2.

Returning to Fig. 1A, on the one surface 10a of the insulating substrate 10, a first conductor land 5 is provided at a position corresponding to the other end 3b of the third coil 3 and is connected to the other end 3b of the third coil 3 through a via hole V3. Further, on the one surface 10a of the insulating substrate 10, a second conductor land 6 is provided at a position corresponding to the other end 4b of the fourth coil 4 and is connected to the other end 4b of the fourth coil 4 through a via hole V4.

Conductors constituting these coils 1 to 4 and the conductor lands 5 and 6 are formed, for example, by thick film screen printing or thin film deposition, or by etching conductors deposited on the surfaces of the insulating substrate 10.

Fig. 2A is a perspective view seen from the one surface 10a which focuses attention on the first coil. The first coil 1 formed on the one surface 10a and the third coil 3 formed on the other surface 10b are connected in series with each other through the via hole V1 at the central portion, and are wound in the same direction. Accordingly, the first coil 1 and the third coil 3 are opposite to each other on both surfaces of the insulating substrate 10 and thus are electromagnetically connected to each other. In this case, the synthetic inductance is higher than that in a case of forming separately the first coil 1 and the third coil 3. In addition, the other end 1b of the first coil 1, and the conductor land 5, which is connected to the other end 3b of the third coil 3 through the via hole V3, are positioned on the same surface.

Fig. 2B is a perspective view seen from the one surface 10a which focuses attention on the second coil. The second coil 2 formed on the one surface 10a and the fourth coil 4 formed on the other surface 10b are connected in series with each other through the via hole V2 at the central portion and are wound in the same direction. Accordingly, the second coil 2 and the fourth coil 4 are opposite to each other on both surfaces of the insulating substrate 10 and thus are electromagnetically connected to each other. In addition, the other end 2b of the second coil 2, and the conductor land 6, which is connected to the other end 4b of the third coil 4 through the via hole V4, are positioned on the same surface.

Further, the first coil 1 and the second coil 2 are electromagnetically connected to each other on the one surface 10a, and the third coil 3 and the fourth coil 4 are electromagnetically connected to each other on the other surface 10b. Of course, both surfaces of the insulating substrate 10 are also electromagnetically connected to each other.

Figs. 3 and 4 are circuit diagrams showing examples where the coupling coil of the invention is used. Fig. 3 shows the construction of a double tuned circuit as an example. In Fig. 3, a varactor diode VD1 is connected parallel to a primary coil L1 composed of a first coil 1 and a third coil 3, and a varactor diode VD2 is connected parallel to a secondary coil L2 composed of a second coil 2 and a fourth coil 4. When a tuning voltage is applied to the varactor diodes VD1 and VD 2, a tuning frequency varies. When the primary coil L1 and the secondary coil L2 are coupled to each other to form a double tuned circuit. In Fig. 3, for example, when the primary coil L1 is connected to an antenna (not shown), the secondary coil L2 constitutes a single tuned circuit.

## Claims

1. A coupling coil comprising:
a first coil (1) spirally formed on one surface (10a) of an insulating substrate (10);
a second coil (2) spirally formed on the one surface (10a) of the insulating substrate (10) so as to spirally rotate around adjacent conductors of the first coil (1) and be concentrically arranged with the first coil (1);
a third coil (3) spirally formed on the other surface (10b) of the insulating substrate (10); and
a fourth coil (4) spirally formed on the other surface (10b) of the insulating substrate (10) so as to spirally rotate around adjacent conductors of the third coil (3) and be concentrically arranged with the third coil (3);
**characterized in that** one end (1a) of the first coil (1) positioned at the central portion of the first coil (1) is connected to one end (3a) of the third coil (3) positioned at the central portion of the third coil (3),
one end (2a) of the second coil (2) positioned at the central portion of the second coil (2) is connected to one end (4a) of the fourth coil (4) positioned at the central portion of the fourth coil (4),
the first coil (1) and the third coil (3) are wound in the same direction on the same perspective plane, and
the second coil (2) and the fourth coil (4) are wound in the same direction on the same perspective plane.

2. The coupling coil according to claim 1,
**characterized in that** a first conductor land (5) is provided at a position on the one surface (10a) corresponding to the other end (3b) of the third coil (3) and is connected to the other end (3b) of the third coil (3) through a third via hole (V3), and
a second conductor land (6) is provided at a position on the one surface (10a) of the insulating substrate (10) corresponding to the other end (4b) of the fourth coil (4) and is connected to the other end (4b) of the fourth coil (4) through a fourth via hole (V4).

3. The coupling coil according to claim 1 or 2,
**characterized in that** the one end (1a) of the first coil (1) and the one end (3a) of the third coil (3) are connected to each other through a first via hole (V1), and
the one end (2a) of the second coil (2) and the one end (4a) of the fourth coil (4) are connected to each other through a second via hole (V2).
